Europäisches Patentamt

European Patent Office

Office européen des brevets

(19)

(11) **EP 1 489 895 A1**

(12) **EUROPEAN PATENT APPLICATION**
published in accordance with Art. 158(3) EPC

(43) Date of publication:
**22.12.2004 Bulletin 2004/52**

(51) Int Cl.⁷: **H05K 7/20**, H01L 23/34, F25D 1/00

(21) Application number: **03720883.2**

(22) Date of filing: **19.03.2003**

(86) International application number:
**PCT/JP2003/003309**

(87) International publication number:
**WO 2003/081971 (02.10.2003 Gazette 2003/40)**

(84) Designated Contracting States:
**AT BE BG CH CY CZ DE DK EE ES FI FR GB GR HU IE IT LI LU MC NL PT RO SE SI SK TR**

(30) Priority: **22.03.2002 JP 2002080530**

(71) Applicant: **SHINDENGEN ELECTRIC MANUFACTURING COMPANY, LIMITED Tokyo, 100-0004 (JP)**

(72) Inventors:
• **JO, Hiroshi, c/o Shindengen Electric Hanno-shi, Saitama 357-8585 (JP)**
• **KITAMORI, Tetsuji, c/o Shindengen Kumamoto Kumamoto-sh, Kumamoto 862-8001 (JP)**

(74) Representative: **Viering, Jentschura & Partner Steinsdorfstrasse 6 80538 München (DE)**

(54) **SIMPLE CONSTANT TEMPERATURE DEVICE FOR ELECTRONIC DEVICE AND METHOD FOR CONTROLLING THE CONSTANT TEMPERATURE DEVICE**

(57) The invention relates to a simplified thermostatic apparatus for an electronic apparatus and its control method achieving thermostatic formation of an electronic apparatus and constituting an object by preventing a deterioration in accuracy by a change in a surrounding temperature, and a highly heat-insulating vessel (1) provided with a radiator (2) capable of making a heat resistance variable is provided with a fan (4) for circulating a gas at inside of the vessel (1), temperature detecting means (7) for detecting a temperature at inside of the vessel (1) and heat resistance controlling means (3) for controlling the heat resistance of the radiator ( 2) in accordance with an output of the temperature detecting means (7).

FIG. 1

EP 1 489 895 A1

**Description**

Technical Field

The present invention relates to a simplified thermostatic apparatus for an electronic apparatus and its control method, particularly relates to a simplified thermostatic apparatus for an electronic apparatus characterized in a constitution for stably operating an electronic apparatus by restraining inner temperature rise by self heat generation of the electronic apparatus requesting accuracy and its control method.

Background Art

Generally, according to an electronic apparatus, the higher the temperature the shorter the life, and in order to lower temperature rise by self heat generation, heat is discharged as much as possible by ventilation utilizing a fan or a heat radiating fin.

Further, in a high accuracy electronic apparatus, in order to maintain accuracy stability, temperature coefficients of a reference power source, error detection, a detecting resistor and the like are reduced as less as possible to realize the accuracy stability, and electronic parts need to select therefor.

In an electrooptical system of a three-dimensional CDSEM (length measuring scanning electron microscope) which is one of such high accuracy electronic apparatus, an electric field lens is used around an object lens for determining a function, and in order to promote a resolution in the three-dimensional CDSEM, simultaneously with designing a lens system having an excellent aberration characteristic, low noise formation and low ripple formation of a high voltage power source for applying a voltage to the electric field lens are indispensable.

For example, as a power source for a main lens in correspondence with 100 nm technology, an output voltage of - 5000 V, a noise of 150 mV$_{p-p}$, and a characteristic and an accuracy of a temperature coefficient of 25 ppm are requested and with regard to the temperature coefficient, temperature control of the power source becomes important.

However, according to the above-described temperature control by ventilation, the accuracy stability is influenced by a change in surrounding temperature, even when a temperature control is carried out by air conditioning or the like, a fluctuation by self heat generation is produced, further, a deterioration in the accuracy is brought about by re-intake of self discharge and therefore, the temperature control is inappropriate as a temperature control method in a high accuracy electronic apparatus.

Further, although in order to maintain the accuracy stability of a high accuracy electronic apparatus, the high accuracy electronic apparatus is put into a thermostat, there poses a problem that it is difficult to downsize a thermostat for controlling temperature by using a heat pump and a heater which have been used in a background art, further, a considerable amount of energy is needed, which is not general.

Therefore, it is an object of the invention to prevent a deterioration in an accuracy by a change in a surrounding temperature by achieving thermostatic formation of an electronic apparatus.

Disclosure of the Invention

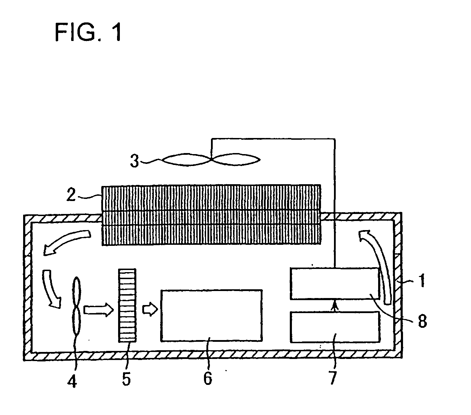

Fig. 1 is a principle constitution view of the invention and an explanation will be given here of means for resolving the problem of the invention in reference to Fig. 1.

In reference to Fig. 1:

(1) The invention is a simplified thermostatic apparatus for an electronic apparatus characterized in comprising a highly heat-insulating vessel 1 provided with a radiator 2 capable of making a heat resistance variable, a fan 4 for circulating a gas at inside of the vessel 1, temperature detecting means 7 for detecting a temperature at inside of the vessel 1, and heat resistance controlling means 3 for controlling the heat resistance of the radiator 2 in accordance with an output of the temperature detecting means 7.

In this way, a change in a surrounding temperature or a deterioration in an accuracy by a fluctuation can be improved by a simple constitution by restraining a fluctuation of heat by self heat generation by installing an electronic apparatus 6 at inside of the highly insulating vessel 1 having the radiator 2 capable of making the heat resistance variable and circulating a gas at inside by the fan 4, uniformly maintaining an inner temperature of the vessel 1 by changing the heat resistance of the radiator 2 and cutting off outside air.

Further, operation of the heat resistance controlling means 3 is controlled by a heat resistance controlling circuit 8.

(2) Further, the invention is characterized in that air is used as the gas and a rectifying plate 5 for rectifying a flow of air is provided at inside of the vessel 1 in the above-described (1).

In this way, it is preferable to provide the rectifying plate 5 since when air is used as the gas, a turbulent flow in accordance with a viscosity thereof is brought about.

(3) Further, the invention is characterized in that as the gas, either of helium gas or mixed gas of helium gas and air is used in the above-described (1).

In this way, when helium gas is used as the gas, the turbulent flow can be eliminated, further, when the mixed gas of helium gas and air is used, the turbulent flow can be reduced.

(4) Further, the invention is characterized in that the radiator 2 comprises an air-cooled radiator and the heat resistance controlling means 3 comprises a wind blowing apparatus provided at outside of the vessel 1 in any one of the above-described (1) through (3).

In this way, when the air-cooled radiator is used as the radiator 2, the wind blowing apparatus may be provided at outside of the vessel 1 in order to make the heat resistance of the radiator 2 variable.

(5) Further, the invention is characterized in that the radiator 2 comprises a liquid-cooled radiator for circulating a cooling fluid at inside thereof and the heat resistance controlling means 3 comprises a flow rate control apparatus for controlling a flow of the cooling fluid to the liquid-cooled radiator in any one of the above-described (1) through (3).

In this way, when the liquid-cooled radiator is used as the radiator 2, the cooling fluid may be made to flow to inside of the liquid-cooled radiator in order to make the heat resistance of the radiator 2 variable.

(6) Further, the invention is characterized in a method of controlling the simplified thermostatic apparatus for an electronic apparatus described in any one of the above-described (1) through (5), characterized in that when an inner temperature of the vessel 1 becomes higher than an operational set temperature, the heat resistance of the radiator 2 is reduced by the heat resistance controlling means 3 and when the inner temperature of the vessel 1 becomes lower than the operational set temperature, the control is stopped by the heat resistance controlling means 3.

In this way, the operational temperature can be maintained constant by controlling the heat resistance of the radiator 2 by the heat resistance controlling means 3.

(7) Further, the invention is a method of controlling a simplified thermostatic apparatus for an electronic apparatus characterized in a method of controlling the simplified thermostatic apparatus for an electronic apparatus described in any one of the above-described (1) through (5), wherein when the inner temperature of the vessel 1 becomes higher than an ON set temperature previously set to be lower than an operational set temperature, the heat resistance of the radiator 2 is reduced by the heat resistance controlling means 3 and when the inner temperature of the vessel 1 becomes lower than an OFF set temperature previously set to be higher than the operational set temperature, the control is stopped by the heat resistance controlling means 3.

In this way, an effect of improving the accuracy stability against a change in a surrounding temperature can further be promoted by making the inner temperature of the vessel 1 constant by restraining a temperature ripple by a heat capacity of the radiator 2 from being brought about by predictively controlling the heat resistance of the radiator 2 such that the inner temperature is maintained at a set temperature by detecting the inner temperature or the like of the vessel 1 rising by heat generation of the electronic apparatus.

(8) Further, the invention is characterized in that the operational set temperature is set to be higher than an environmental temperature in the above-described (6) or (7).

In this way, the effect of improving the accuracy stability against the change in the surrounding temperature can be promoted by making the operational set temperature higher than the environmental temperature, particularly, by setting the operational set temperature higher than a lower limit of a saturated temperature of the apparatus.

Brief Description of the Drawings

Fig. 1 is an explanatory view of a principle constitution of the invention.
Fig. 2 illustrates outline constitution views of a simplified thermostatic apparatus for an electronic apparatus according to a first embodiment of the invention.
Fig. 3 is a time chart showing a method of operating the simplified thermostatic apparatus for an electronic apparatus according to the first embodiment of the invention.
Fig. 4 is a time chart showing a method of operating a simplified thermostatic apparatus for an electronic apparatus according to a second embodiment of the invention.
Fig. 5 illustrates outline constitution views of a simplified thermostatic apparatus for an electronic apparatus according to a third embodiment of the invention.
Fig. 6 is a time chart showing a method of operating the simplified thermostatic apparatus for an electronic apparatus according to the third embodiment of the invention.

Best Mode for Carrying Out the Invention

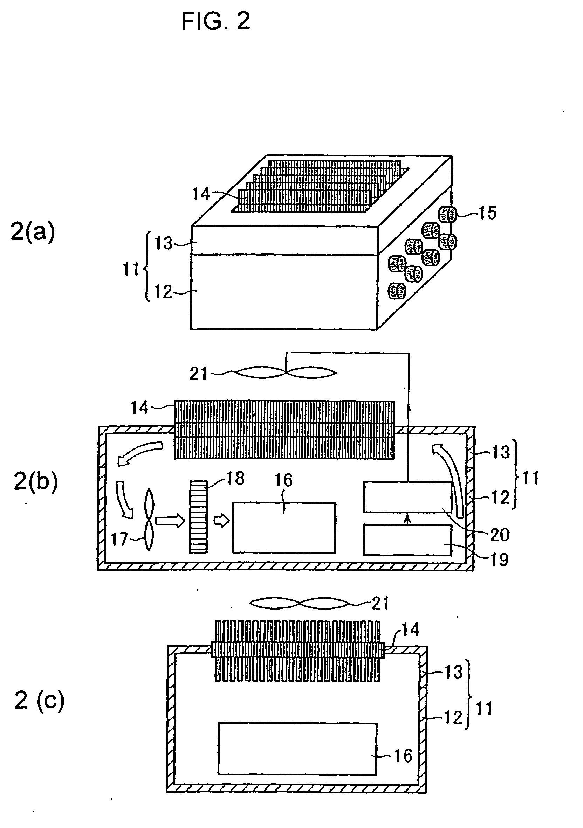

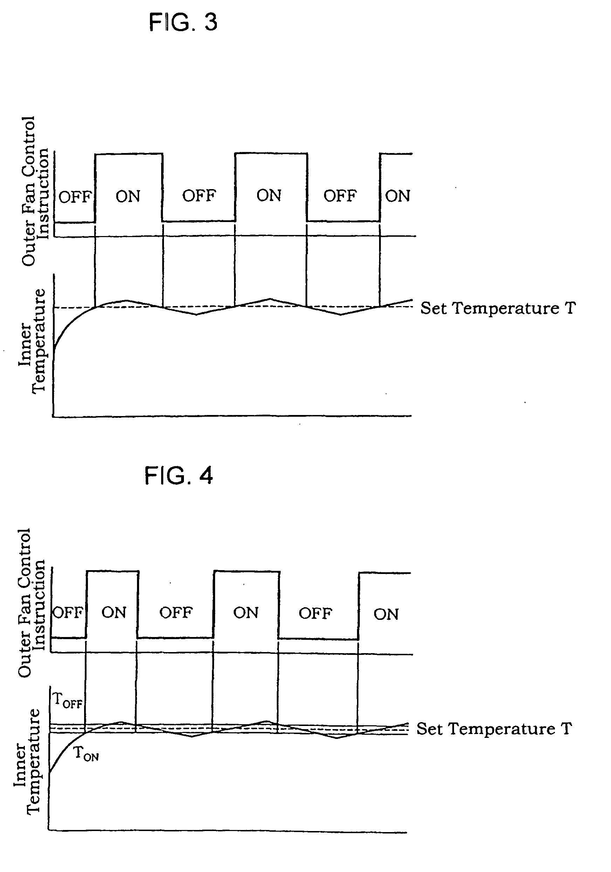

An explanation will be given here of a simplified thermostatic apparatus for an electronic apparatus according to a first embodiment of the invention in reference to Fig. 2 and Fig. 3.

In reference to Figs. 2(a) through 2(c):

Fig. 2(a) is outline perspective view of a simplified thermostatic apparatus for an electronic apparatus according to the first embodiment of the invention, Fig. 2(b) is a perspective side view, further, Fig. 2 (c) is a perspective total face view.

A highly heat-insulating vessel 11 for storing an electronic apparatus 16 of a high voltage power source or the like comprises a hermetically sealed structure by a vessel main body portion 12 and an upper lid portion 13, and the upper lid portion 13 is provided with a radiator 14 for radiating heat at inside of the vessel 11 to outside thereof to penetrate head and tail of the upper lid portion 13.

An outer diameter dimension of the vessel 11 in this case is constituted such that a height is 230 mm, a width is 400 mm, and a length is 600 mm, and 45 pieces of BNC connectors 15 for outputting a power source are taken out from one wall face thereof.

Further, the vessel 11 is constituted by polycarbonate having a heat conductivity of 0.19 W/m·K, further, a thickness thereof is made to be, for example, 4 mm.

Meanwhile, the radiator 14 is constituted by a structure in which a main body portion comprises aluminum, for example, having an area of 200 mm × 500 mm and a thickness of 3.5 mm, and 29 sheets of fins each having a thickness of 1.3 mm and a width of 28 mm in an up and down direction are attached to the main body portion.

Inside of the vessel 11 is provided with an inner fan 17 for circulating air at inside thereof and provided with a rectifying plate 18, and air to be circulated is rectified by the rectifying plate 18 and thereafter blown to the electronic apparatus 16 to lower a temperature of the electronic apparatus 16.

Further, inside of the vessel 11 is provided with a temperature detector 19 comprising, for example, a thermo couple sensor and an outer fan control circuit 20, and operation of an outer fan 21 provided at outside of the vessel 11 is controlled by the outer fan control circuit 20 based on a detected output of the temperature detector 19.

A heat resistance of the radiator 14 is made to be variable bywind impinging on the radiator 14 by controlling the operation of the outer fan 21 such that an inner temperature of the vessel 11 becomes constant.

Next, an explanation will be given of a method of operating the simplified thermostatic apparatus for an electronic apparatus according to the first embodiment of the invention in reference to Fig. 3.

In reference to Fig. 3:

Fig. 3 is a time chart showing a method of operating the simplified thermostatic apparatus for an electronic apparatus according to the first embodiment of the invention.

First, at an onset of conducting electricity to the electronic apparatus 16, the inner temperature of the vessel 11 is equal to a surrounding temperature, the radiator 14 on an inner side of the vessel and the electronic apparatus 16 are forcedly cooled by air by the inner fan 17 and therefore, the heat resistance is small, however, the radiator 14 on an outer side of the vessel is naturally cooled by air and therefore, the heat resistance is large, the electronic apparatus 16 and outer air are shielded from each other and therefore, the inner temperature rises with time by heat generation of the electronic apparatus 16.

The outer fan control circuit 20 monitors the inner temperature of the vessel 11 by the temperature detector 19 and reduces the heat resistance of the radiator 14 by making the outer fan 21 ON to rotate when a set temperature T [°C] is reached.

Thereby, the temperature of the radiator 14 falls, rise of the inner temperature of the vessel 11 is retarded to finally stop, and when the outer fan 21 continues to rotate further, the inner temperature is turned to fall.

Successively, at a stage of detecting that the inner temperature becomes lower than the set temperature T [°C] by the temperature detector 19, rotation of the outer fan 21 is stopped by the outer fan control circuit 20.

By the above-described simple control of repeating ON/OFF of the outer fan 21 aiming at the set temperature T [°C], the inner temperature of the vessel 11 can be made to be proximate to the set temperature.

For example, when a self heat generating amount of the electronic apparatus 16 is set to 100 W, a heat resistance $R_{c1}$ of the radiator 14 in natural air cooling is set to 0.5°C/W, a heat resistance $R_{c2}$ in forced air cooling is set to 0.05°C/W, a heat resistance $R_p$ of the vessel 11 is set to 1.0°C/W, and a surrounding temperature is set to 20°C, a heat resistance of the thermostatic vessel in natural air cooling, that is, a synthesized heat resistance $R_1$ of the heat resistance $R_{c1}$ of the radiator 14 in natural air cooling and the heat resistance $R_p$ of the vessel 11 becomes as follows.

$$R_1 = R_{c1} \times R_p / (R_{c1} + R_p) \cong 0.33°C/W$$

Further, a heat resistance of the thermostatic vessel in forced air cooling, that is, a synthesized heat resistance $R_2$ of the heat resistance $R_{c2}$ in forced air cooling and the heat resistance $R_p$ of the vessel becomes as follows.

$$R_2 = R_{c2} \times R_p / (R_{c2} + R_p) \cong 0.033°C/W$$

Therefore, when the outer fan 21 is not operated, the inner temperature of the vessel rises by self heat generation of the electronic apparatus 16 and a saturated temperature $T_{s1}$ rises as follows.

$$T_{s1} = 20 [°C] + 0.33 [°C/W] \times 100 [W] = 55 [°C]$$

Meanwhile, when forced air cooling is carried out, a saturated temperature $T_{s2}$ can be restrained to a temperature shown below.

$$T_{s2} = 20 \text{ [°C]} + 0.03 \text{ [°C/W]} \times 100 \text{ [W]} = 22 \text{ [°C]}$$

Hence, when the set temperature T is set to about 30°C more less higher than a room temperature, even when the surrounding temperature is more less changed, the saturated temperature $T_{s2}$ by the temperature control mechanism is about 22°C in the case of above-described constitution and therefore, the temperature at inside of the vessel can be maintained to the set temperature by the function of temperature control.

In this way, according to the first embodiment of the invention, the thermostatic apparatus is constituted by the mechanism of circulating air at inside of the vessel, the radiator penetrating the wall face of the vessel, and the resin vessel having a simple constitution of providing the outer fan for making the heat resistance of the radiator variable without adopting a large-scaled heat insulating structure or a large scaled forced cooling structure and therefore, small-sized formation and low cost formation of the thermostatic apparatus can be achieved.

However, in the case of the temperature control method shown in Fig. 3, there poses a problem of bringing about a temperature ripple since the change in the inner temperature of the vessel 11 retardedly follows operation of rotating or stopping the outer fan 21 by influence of a heat capacity of the radiator 14 and therefore, an explanation will successively be given of a method of controlling the temperature improving the temperature ripple in reference to Fig. 4.

In reference to Fig. 4:

Fig. 4 is a time chart showing a method of operating a simplified thermostatic apparatus for an electronic apparatus according to a second embodiment of the invention.

Further, the second embodiment is quite similar to the above-described first embodiment except an apparatus constitution of the simplified thermostatic apparatus for an electronic apparatus.

As shown by Fig. 4, the temperature ripple is reduced by changing to control temperatures for determining timings of rotating and stopping the outer fan 21 by an amount of correcting a delay in the change of the inner temperature.

That is, when the temperature rises, rotation of the outer fan 21 is started at a fan operating temperature $T_{on}$ [°C] which is slightly lower than the set temperature T [°C], and when the temperature falls, the outer fan 21 is stopped at a fan stopping temperature $T_{off}$ [°C] which is slightly higher than the set temperature T [°C].

Further, set values of the fan operating temperature $T_{on}$ [°C] and the fan stopping temperature $T_{off}$ [°C] depend on an amount of inner heat generation, and the heat capacity of the radiator 14, a difference between the set temperature T [°C] and the surrounding temperature and the like, and set, for example, as follows.

$$T_{on} \text{ [°C]} = T \text{ [°C]} - 0.1°C$$

$$T_{off} \text{ [°C]} = T \text{ [°C]} + 0.1°C$$

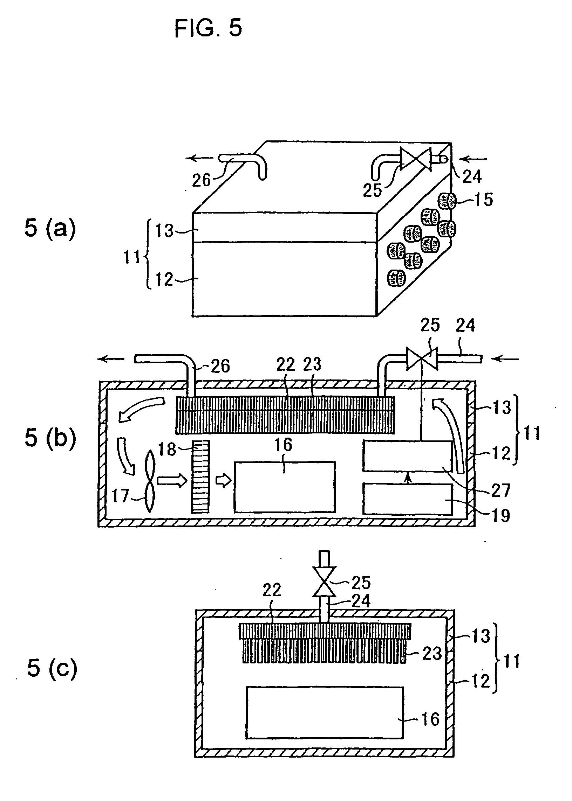

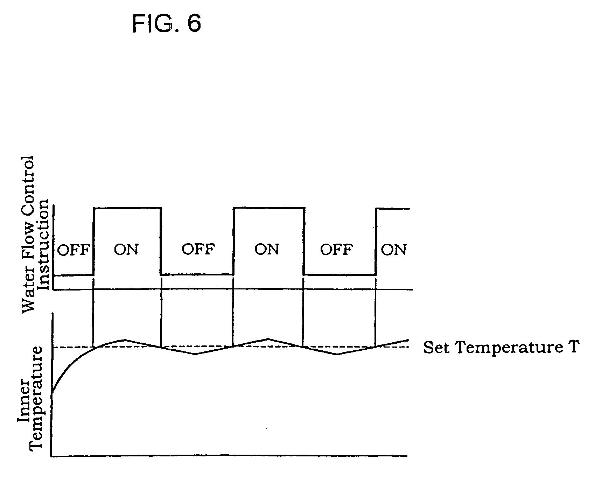

Next, an explanation will be given of a simplified thermostatic apparatus for an electronic apparatus according to a third embodiment of the invention in reference to Fig.5 and Fig.6.

In reference to Figs. 5(a) through 5(c):

Fig. 5(a) is an outline perspective view of a simplified thermostatic apparatus for an electronic apparatus according to a third embodiment of the invention, Fig. 5(b) is a perspective side view, further, Fig. 5(c) is a perspective total face view.

The highly heat-insulating vessel 11 for storing the electronic apparatus 16 of a high voltage power source or the like comprises the hermetically sealed structure by the vessel main body 12 and the upper lid portion 13, and inside of the upper lid portion 13 is attached with a water-cooled radiator 22 for circulating cooling water for absorbing heat at inside of the vessel 11 to discharge to outside thereof.

The water-cooled radiator 22 is provided with a fin 23 directed to inside of the vessel 11, the water-cooled radiator 22 includes a cooling water intake valve 25 and cooling water is injected from a water feed pipe 24 penetrating the upper lid portion 13, and cooling water absorbing heat of the inside is discharged from a water discharge pipe 26 penetrating the upper lid portion 13.

A size, a structure, a material and the like of the vessel 11 in this case are similar to those of the above-described embodiment.

Inside of the vessel 11 is provided with the inner fan 17 for circulating air at inside thereof and provided with the rectifying plate 18, and air to be circulated is rectified by the rectifying plate 18 and thereafter is blown to the electronic apparatus 16 to thereby lower the temperature of the electronic apparatus 16.

Further, inside of the vessel 11 is provided with the temperature detector 19 comprising a thermocouple sensor and an intake valve control circuit 27 for controlling to open and close the cooling water intake valve 25 provided at the water feed pipe 24 and the cooling water intake valve 25 provided at the outside of the vessel 11 is controlled to open and close by the intake valve control circuit 27 based on the detected output of the temperature detector 19.

A heat resistance of the water-cooled radiator 22 is made to be variable by cooling water flowing at inside of the water-cooled radiator 22 by controlling to open and close the cooling water intake valve 25 such that the inner temperature of the vessel 11 becomes constant.

Next, an explanation will be given of a method of operating the simplified thermostatic apparatus for an electronic apparatus in according to a third embodiment of the invention in reference to Fig. 6.

In reference to Fig. 6:

Fig. 6 is a time chart showing a method of operating the simplified thermostatic apparatus for an electronic apparatus according to the third embodiment of the invention.

First, at an onset of conducting electricity to the electronic apparatus 16, the inner temperature of the vessel 11 is equal to the surrounding temperature, the water-cooled radiator 22 stays to be stopped, heat conduction of the water feed pipe 24 and the water discharge pipe 26 is also small and therefore, the electronic apparatus 16 and the outside air are shielded from each other and the inner temperature rises with temperature by heat generation of the electronic apparatus 16.

The intake valve control circuit 27 monitors the inner temperature of the vessel 11 by the temperature detector 19 and reduces the heat resistance by making cooing water flow to the water-cooled radiator 22 by opening the cooling water intake valve 25 when the set temperature T [°C] is reached.

Thereby, the temperature of the water-cooled radiator 22 falls, rise of the inner temperature is retarded to finally turn to fall, successively, when the inner temperature becomes lower than the set temperature T [°C] , cooling water is stopped from being taken in by closing the cooling water intake valve 25.

As described above, by making cooling water flow or stop to or from the water-cooled radiator 22 in accordance with the inner temperature, the inner temperature of the vessel 11 can be maintained within a constant range.

Although an explanation has been given of the respective embodiments of the invention as described above, the invention is not limited to constitutions and conditions described in the respective embodiments but can variously be modified.

For example, although according to the above-described first embodiment, the inner temperature is used for controlling the outer fan, not only the inner temperature but also the temperature of the radiator may be detected and the temperature of the radiator may be used for correcting the timings of rotating and stopping the outer fan, thereby, the temperature ripple can be reduced.

Further, although according to the above-described first and second embodiments, the outer fan is controlled by simply making the outer fan ON/OFF , by variably controlling a revolution number of the outer fan, finer temperature control can be carried out.

Further, although according to the above-described first and second embodiments, in order to rectify the flow of circulating air, the rectifying plate is arranged on the downstream side of wind of the inner fan and on the upstream side of wind of the electronic apparatus, arrangement of the rectifying plate is arbitrary and the rectifying plate may be arranged at a position of restraining a turbulence in air flow in accordance with arrangements and structures of various members at inside of the vessel.

Further, although according to the above-described first and second embodiments, the atmosphere at inside of the hermetically shield vessel is constituted by the outer atmosphere, when air is used, a turbulent flow in accordance with circulation is brought about by the viscosity of air and therefore, in order to reduce an influence of such a turbulent flow, He gas or a mixed gas of He gas and air may be used for the atmosphere.

Further, when He gas is used, hermetically sealing performance of the hermetically sealed vessel needs to further promote.

Further, although the temperature ripple is brought about in the above-described third embodiment by influence of the heat capacity of the water-cooled radiator, also in this case, similar to the above-described second embodiment, the temperature ripple can be reduced by measuring the temperature of the water-cooled radiator and correcting the timings of opening and closing the cooling water intake valve.

Further, also in this case, the inner temperature can be maintained within a constant range by controlling a flow rate of cooling water not only by opening and closing the cooling water the intake valve but also variably controlling the cooling water intake valve.

Further, although according to the above-described third embodiment, water is used as a cooling medium, pure water, particularly pure water added with hydrogen maybe used, further, the cooling medium is not limited to water but other cooled liquid or cooled gas may be circulated.

Further, although according to the above-described respective embodiments, the vessel is constituted by polycarbonate, the vessel is not limited to polycarbonate but a member having heat-insulating performance to a degree the same as or more than that of the polycarbonate will do, particularly, a member excellent in molding performance and shape workability will do.

Further, the outer shape dimension and the thickness of the material of the vessel and the outer diameter dimension and the material and the like of the radiator shown in the above-described respective embodiments are only an example and may pertinently be determined in accordance with the size and the self heat generating amount of the electronic apparatus used.

Further, although according to the above-described respective embodiments, the electronic apparatus is directly mounted onto the vessel main body portion, a corrugated ceramic plate may be arranged between the electronic apparatus and a bottom face of the vessel main body portion, thereby, an effect of temperature control only by the radiator can be promoted by restraining heat radiation by heat conduction via the bottom face of the vessel main body portion.

Further, in such a corrugated ceramic plate, by laminating the ceramic plates in two stages such that folding directions thereof are orthogonal to each other, the effect can further be promoted.

Further, although according to the above-described respective embodiments, as the electronic apparatus, an explanation has been given by keeping the high voltage power source for the three-dimensional CDSEM in mind, the electronic apparatus is not limited to the high voltage power source for the three-dimensional CDSEM but may be a power source apparatus of other electron microscope, further, the invention is applicable generally to a power source apparatus which needs temperature control.

Industrial Applicability

As described above, by the simplified thermostatic apparatus for an electronic apparatus and the control method according to the invention, a thermostatic environment having a high function can be realized, further, the invention is suitable for promotion of temperature controllability and low cost formation of the high accuracy electronic apparatus.

**Claims**

1. A simplified thermostatic apparatus for an electronic apparatus, said simplified thermostatic apparatus **characterized in** comprising a highly heat-insulating vessel provided with a radiator capable of making a heat resistance variable, a fan for circulating a gas at inside of the vessel, temperature detecting means for detecting a temperature at inside of the vessel, and heat resistance controlling means for controlling the heat resistance of the radiator in accordance with an output of the temperature detecting means.

2. The simplified thermostatic apparatus for an electronic apparatus according to Claim 1, **characterized in that** air is used as the gas and a rectifying plate for rectifying a flow of air is provided at inside of the vessel.

3. The simplified thermostatic apparatus for an electronic apparatus according to Claim 1, **characterized in that** as the gas, either of helium gas or a mixed gas of helium gas and air is used.

4. The simplified thermostatic apparatus for an electronic apparatus according to Claim 1, **characterized in that** the radiator comprises an air-cooled radiator and the heat resistance controlling means comprises a wind blowing apparatus provided at outside of the vessel.

5. The simplified thermostatic apparatus for an electronic apparatus according to Claim 1, **characterized in that** the radiator comprises a liquid-cooled radiator for circulating a cooling fluid at inside thereof and the heat resistance controlling means comprises a flow rate control apparatus for controlling a flow of the cooling fluid to the liquid-cooled radiator.

6. A method of controlling a simplified thermostatic apparatus for an electronic apparatus **characterized in** a method of controlling the simplified thermostatic apparatus for an electronic apparatus according to Claim 1, wherein when an inner temperature of the vessel becomes higher than an operational set temperature, the heat resistance of the radiator is reduced by the heat resistance controlling means and when the inner temperature of the vessel becomes lower than the operational set temperature, the control is stopped by the heat resistance controlling means.

7. A method of controlling a simplified thermostatic apparatus for an electronic apparatus **characterized in** a method of controlling the simplified thermostatic apparatus for an electronic apparatus according to Claim 1, wherein when an inner temperature of the vessel becomes higher than an ON set temperature previously set to be lower than an operational set temperature, the heat resistance of the radiator is reduced by the heat resistance controlling means and when the inner temperature of the vessel becomes lower than an OFF set temperature previously set to be higher than the operational set temperature, the control is stopped by the heat resistance controlling means.

8. The method of controlling the simplified thermostatic apparatus for an electronic apparatus according to Claim 6 or 7, **characterized in that** the operational set temperature is set to be higher than an environmental temperature.

FIG. 1

## FIG. 2

2(a)

2(b)

2 (c)

FIG. 3

Set Temperature T

FIG. 4

Set Temperature T

FIG. 5

5 (a)

5 (b)

5 (c)

## FIG. 6

Set Temperature T

**EP 1 489 895 A1**

## INTERNATIONAL SEARCH REPORT

| International application No. |
|---|
| PCT/JP03/03309 |

**A. CLASSIFICATION OF SUBJECT MATTER**
Int.Cl$^7$ H05K7/20, H01L23/34, F25D1/00

According to International Patent Classification (IPC) or to both national classification and IPC

**B. FIELDS SEARCHED**

Minimum documentation searched (classification system followed by classification symbols)
Int.Cl$^7$ H05K7/20, H01L23/34, F25D1/00

Documentation searched other than minimum documentation to the extent that such documents are included in the fields searched

| | | | |
|---|---|---|---|
| Jitsuyo Shinan Koho | 1922–1996 | Jitsuyo Shinan Toroku Koho | 1996–2003 |
| Kokai Jitsuyo Shinan Koho | 1971–2003 | Toroku Jitsuyo Shinan Koho | 1994–2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 10-311638 A (Fujitsu Ltd.),<br>24 November, 1998 (24.11.98),<br>Full text; all drawings<br>(Family: none) | 1,4<br>2,3,5-8 |
| X<br>Y | JP 9-307257 A (Fujitsu General Ltd.),<br>28 November, 1997 (28.11.97),<br>Full text; all drawings<br>(Family: none) | 1,5<br>2-4,6-8 |
| Y | JP 6-268388 A (Nippon Telegraph And Telephone Corp.),<br>22 September, 1994 (22.09.94),<br>Full text; all drawings<br>(Family: none) | 1-8 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 April, 2003 (10.04.03) | 22 April, 2003 (22.04.03) |

| Name and mailing address of the ISA/<br>Japanese Patent Office | Authorized officer |
|---|---|
| Facsimile No. | Telephone No. |

Form PCT/ISA/210 (second sheet) (July 1998)

13

## INTERNATIONAL SEARCH REPORT

International application No.

PCT/JP03/03309

| C (Continuation). DOCUMENTS CONSIDERED TO BE RELEVANT | | |
|---|---|---|
| Category* | Citation of document, with indication, where appropriate, of the relevant passages | Relevant to claim No. |
| Y | JP 2947671 B2 (Toshiba Corp.), 02 July, 1999 (02.07.99), Full text; all drawings (Family: none) | 1-8 |
| Y | JP 4-372198 A (Fujitsu Ltd.), 25 December, 1992 (25.12.92), Full text; all drawings (Family: none) | 2 |
| Y | JP 1-98298 A (Fujitsu Ltd.), 17 April, 1989 (17.04.89), Full text; all drawings (Family: none) | 3 |

Form PCT/ISA/210 (continuation of second sheet) (July 1998)